# EUROPEAN PATENT APPLICATION

(11) **EP 4 319 523 A1**
(43) Date of publication of application: **07.02.2024**
(21) Application number: 23157400.5
(22) Date of filing: 17.02.2023
(51) Int. Cl.: H05K 7/20

(54) **ADAPTER AND SYSTEM FOR THERMAL MANAGEMENT OF COMPUTING SYSTEMS**

(30) Priority: 01.08.2022 US 202217878671
(71) Applicant: Google LLC, Mountain View, CA 94043 (US)
(72) Inventor: ZHANG, Feini, Mountain View, 94043 (US); ZUO, Xu, Mountain View, 94043 (US); LAU, Michael Chi Kin, Mountain View, 94043 (US); IYENGAR, Madhusudan K., Mountain View, 94043 (US)
(74) Representative: Betten & Resch

(57) **Abstract**

An adapter for coupling a liquid cooling loop subassembly of a computing system to a device rack manifold includes a main body, a first connector disposed on the main body, a second connector disposed on the main body, and a flow control device disposed between the first and second connectors. The first connector couples the adapter to a coupling of the liquid cooling loop subassembly. The second connector couples the adapter to the device rack manifold. The flow control device may be configured to regulate a flow rate of liquid coolant through the liquid cooling loop subassembly. The adapter may be further incorporated into a rack assembly or multi-rack assembly to achieve thermal management of multiple computing systems with cooling loop subassemblies.

## Description

### BACKGROUND

This application relates to the field of electronics, and particularly thermal management and cooling of chip assemblies utilizing liquid cooling. Liquid cooling can be used within computing equipment and on data center racks to aid in the reduction of heat generated by microelectronic elements with the chip assemblies, as well as heat generated by components external to the assembly.

Operating and maintaining large-scale computing systems can be costly. These computing systems are typically stored in data centers, which require expensive hardware and equipment, as well as real estate and personnel to maintain the equipment stored in the data centers. To minimize costs, data center racks and the equipment thereon are designed to be compact and capable of functioning over extended periods of time, as well as modular to accommodate changing architecture and configuration of components within the computing system.

Given the high-power outputs of each computing system, as well as the other equipment in the data rack and in the data center, high levels of heat are generated. Significant heat within and around the computing systems threaten the lifespan and operation of the computing system.

Liquid cooling is one method used to reduce heat in the system and to maintain components, such as chip assemblies and microprocessors, within the system within operating temperature limits. Liquid cooling allows for removal of the excess heat with heat transfer fluid pumped into a cooling device and the heated return cooling liquid pumped out of the device.

At the server and rack level, liquid cooling of computing systems housed within the server rack creates challenges. Among other problems, flow rate and pressure drop are inconsistent throughout the system. Further, heterogeneous systems that require different computing systems within the same rack require customized manual connections for each computing system within the rack. These problems increase the overall time to cool and the amount of power expended, which results in inefficient cooling of the system, as well as increased cost of cooling the computing systems.

### BRIEF SUMMARY

According to an aspect of the disclosed embodiments, an adapter for coupling a liquid cooling loop subassembly of a computing system to a device rack manifold includes a main body, a first connector, a second connector, and a flow control device. The first connector is disposed on the main body and couples the adapter to a coupling of the liquid cooling loop subassembly. The second connector is disposed on the main body and couples the adapter to the device rack manifold. The flow control device is disposed between the first and second connectors and is configured to regulate a flow rate of liquid coolant through the liquid cooling loop subassembly.

According to another aspect of the disclosure, a device rack system includes a supply manifold, a return manifold, a plurality of supply adapters, and a plurality of return adapters. The supply manifold has a plurality of supply inlet connections configured to distribute a cooling liquid. The return manifold has a plurality of return outlet connections configured to receive the cooling liquid. The plurality of supply adapters each have a supply adapter manifold connection configured to connect with a corresponding one of the supply inlet connections and a supply coupling configured to couple with a corresponding cooling liquid subassembly. The plurality of return adapters each have a return adapter manifold connection configured to connect with a corresponding one of the return outlet connections.

Another aspect of the disclosure focuses on a method for cooling a computing system in a device rack comprising attaching a cooling loop assembly configured to cool components of the computing system to the device rack. The attaching further comprises: connecting a first connector of a supply adapter to a manifold supply inlet of a supply manifold for cooling liquid; connecting a second connector of the supply adapter to a supply coupling of a pre-existing cooling loop subassembly; connecting a first connector of a return adapter to a manifold return outlet of a return manifold configured to receive heating cooling liquid; and connecting a second connector of the return adapter to a return coupling of the pre-existing cooling loop subassembly.

### BRIEF DESCRIPTION OF THE DRAWINGS

Various embodiments of the presently disclosed embodiments may be more fully understood with reference to the following detailed description when read with the accompanying drawings, in which:
FIGURE 1 is an example schematic of a top view of a computing system with a cooling loop assembly according to aspects of the disclosure;
FIGURE 2 is an example schematic view of a supply adapter for connection of a cooling loop subassembly to a supply manifold, according to aspects of the disclosure;
FIGURE 3 is an example schematic view of a return adapter for connection of a cooling loop subassembly to a return manifold, according to aspects of the disclosure;
FIGURE 4 is an example schematic of a front view of a rack system housing the computing system with cooling loop assembly of FIGURE 3 and other computing systems, according to aspects of the disclosure;
FIGURE 5 is an example schematic of the computing system, and cooling loop assembly of FIGURE 4, in an example cooling system, according to aspects of the disclosure;
FIGURE 6 is an example schematic view of another supply adapter for connection of a cooling loop subassembly to a supply manifold, according to as aspects of the disclosure;
FIGURE 7 is an example schematic view of another return adapter for connection of a cooling loop subassembly to a return manifold, according to aspects of the disclosure;
FIGURE 7A is an example schematic view of another supply adapter for connection of a cooling loop subassembly to a return manifold, according to aspects of the disclosure;
FIGURE 7B is an example schematic view of another return adapter for connection of a cooling loop subassembly to a return manifold, according to aspects of the disclosure;
FIGURE 8 is an example schematic of a front view of a rack system housing a plurality of computing systems and the supply and return adapters of FIGURES 6 and 7, according to aspects of the disclosure;
FIGURE 9A is a chart illustrating an example pressure drop at each computing system housed in an example rack system shown in FIGURE 9C;
FIGURE 9B is a chart illustrating an example flow rate at each computing system in the example rack system shown in FIGURE 9C;
FIGURE 9C is an example rack system identical to the rack system of FIGURE 4;
FIGURE 10A is a chart illustrating an example pressure drop at each computing system housed in an example rack system shown in FIGURE 10C;
FIGURE 10B is a chart illustrating an example flow rate at each computing system in the example rack system shown in FIGURE 10C;
FIGURE 10C is an example rack system identical to the rack system of FIGURE 8;
FIGURE 10D is a chart illustrating an example pressure drop at each computing system housed in an example rack system shown in FIGURE 10F;
FIGURE 10E is a chart illustrating an example flow rate at each computing system in the example rack system shown in FIGURE 10F;
FIGURE 10F is an example rack system that includes components identical to the rack system of FIGURE 9C;
FIGURE 10G is a chart illustrating an example pressure drop at each computing system housed in an example rack system shown in FIGURE 10I;
FIGURE 10H is a chart illustrating an example flow rate at each computing system in the example rack system shown in FIGURE 10I;
FIGURE 10I is an example rack system that includes components identical to the rack system of FIGURE 10C;
FIGURE 10J is a chart illustrating an example pressure drop at each computing system housed in an example rack system shown in FIGURE 10L;
FIGURE 10K is a chart illustrating an example flow rate at each computing system in the example rack system shown in FIGURE 10L;
FIGURE 10L is an example rack system that includes components similar to the rack system of FIGURE 10F, except that the example supply and return adapters of the first system include flow control devices;
FIGURE 11A is an example schematic of the rack system of FIGURE 4 implemented within an example cooling system, according to aspects of the disclosure;
FIGURE 11B is a chart illustrating an example flow rate at each device rack system in the cooling system of FIGURE 11A;
FIGURE 12A is an example schematic of the rack system of FIGURE 8 implemented within an example cooling system, according to aspects of the disclosure;
FIGURE 12B is a graph illustrating an example flow rate at each device rack system in the cooling system of FIGURE 12A;
FIGURE 13A is a graph illustrating pressure drop versus flow rate for a system using an adapter with a flow rate control device and a system that does not utilize an adapter with a flow rate control device;
FIGURE 13B is a graph illustrating power versus flow rate for a system using an adapter with a flow rate control device and a system that does not utilize an adapter with a flow rate control device;
FIGURE 14 is a schematic supply adapter according to aspects of the disclosure;
FIGURE 15 is a schematic view of a return adapter according to aspects of the disclosure;
FIGURE 16 is a schematic supply adapter according to aspects of the disclosure;
FIGURE 17 is a schematic view of a return adapter according to aspects of the disclosure;
FIGURE 18 is a schematic supply adapter according to aspects of the disclosure; and
FIGURE 19 is a schematic view of a return adapter according to aspects of the disclosure.

### DETAILED DESCRIPTION

Liquid cooling systems and cold plates are used to dissipate heat within chip assemblies, computing systems, and data sever rack systems. Liquid cooled processors require higher coolant flow rate to maintain the computing performance and system reliability. As chip power increases, liquid flow rate must also increase to keep up with increased heat created by the chips. This can lead to significant rise in pressure drop through connections for cooling loop assemblies. Further, pumping power consumed by pressure drop in connectors does not contribute to cooling.

To address the shortcomings associated with supplying a higher flow rate at increased power and cost, an improved liquid cooling system is disclosed. In accordance with aspects of the disclosure, the improved cooling system can include adapters designed to couple a pre-existing liquid cooling loop subassembly of a computing system to the rack manifold. In some examples, a supply adapter can be respectively coupled to the supply coupling of the pre-existing liquid cooling loop subassembly. Similarly, a return adapter can be respectively coupled to the return supply coupling of a pre-existing liquid cooling loop subassembly. This allows for the design of adapters that are configured to couple a rack manifold to any computing system with a pre-existing cooling loop specific to that computing system without redesigning the entire pre-existing liquid cooling assembly of the computing system. It further allows for the use of different types and sizes of connectors, flexibility with rack machines and configurations, and easier hose management.

The use of a supply adapter and/or return adapter also provides the ability for an operator to incorporate additional features that may help to regulate one or more aspects of the cooling liquid, such as flow rate, particulate matter within the cooling liquid, and monitoring. For example, without limitation, the supply and return adapters can further include flow control devices, such as valves, auxiliary pumps, and the like to regulate the flow rate through the cooling loop, filters to filter particulate matter within the cooling liquid, and monitoring of various aspects of the cooling liquid and/or monitoring of other aspects of an overall cooling system.

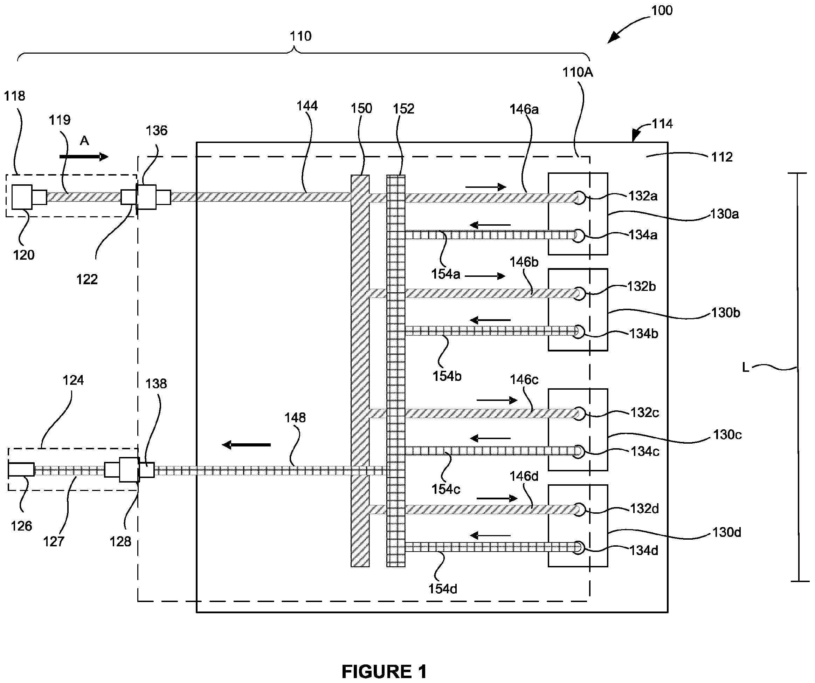

FIGURE 1 is an example system 100 that may be a server tray level computing system that includes a cooling loop assembly 110 that facilitates thermal management and liquid cooling of microelectronic devices (not shown) on a circuit board 112 of a computing device 114. Cooling loop assembly 110 includes an example pre-existing cooling loop subassembly 110A ("PE subassembly"), a supply adapter 118 for connection of the PE subassembly 110A to a cooling liquid supply, such as a supply manifold (not shown), and a return adapter 124 for connection of the PE subassembly 110A to a return, such as a return manifold (not shown). The supply adapter 118 and return adapter 124 may be used to couple the respective supply and return manifolds with a system supply coupling 136 and system return coupling 138 of the PE subassembly 110A.

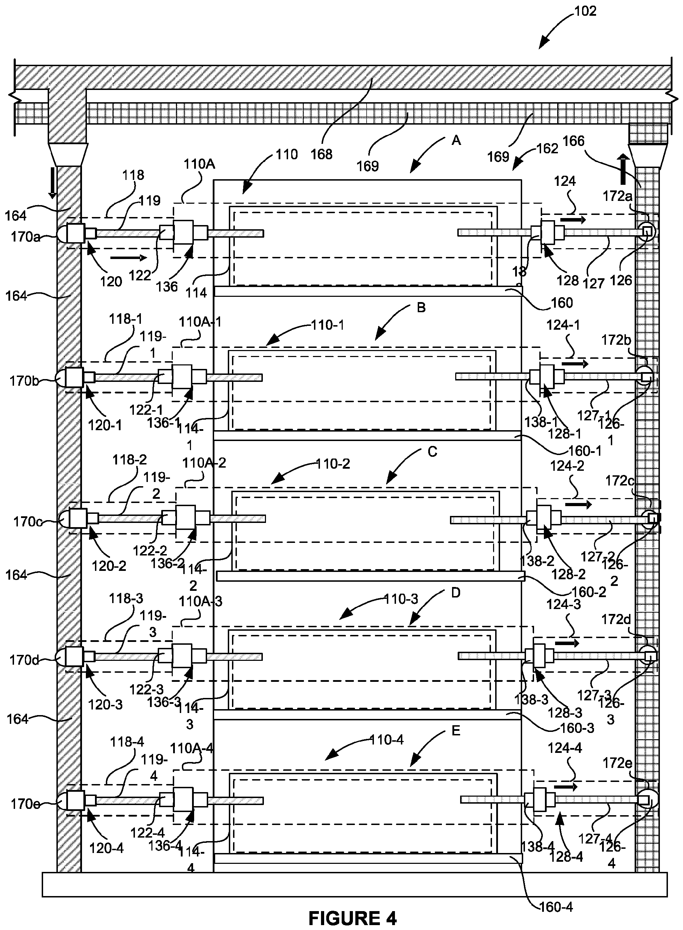

The circuit board 112 may include a motherboard, main board, or the like. In this example, the cooling loop assembly 110 may be the only loop implemented on the circuit board 112 for cooling all components connected to the cooling loop assembly 110 on the circuit board 112. Cooling loop assembly 110 and corresponding computing device 114 may be one of a plurality of cooling loops and computing devices in a data center server rack (*see* FIGURE 4), but in other examples the cooling loop 110 may be utilized as part of a stand alone individual computing system.

The PE subassembly 110A may be a cooling loop that takes on any desired configuration to allow for liquid cooling of components on the circuit board 112. In this example, the PE subassembly 110A (and the overall cooling loop assembly 110) may be fluidly connected to each of the cooling devices 130a, 130b, 130c, 130d on the circuit board 112. Each cooling device 130a, 130b, 130c, 130d may include a respective supply inlet 132a, 132b, 132c, 132d and a return outlet 134a, 134b, 134c, 134d. As shown, the PE subassembly 110A includes a pre-existing loop supply coupling 136 ("PE supply coupling") and a pre-existing loop return coupling ("PE return coupling") 138, which may be collectively referred to as PE couplings. In this example, the cooling loop may be a network of hoses connected to one another, but in other examples, any mechanism, such as pipes, conduits, or the like that can allows for fluid interconnection may be used.

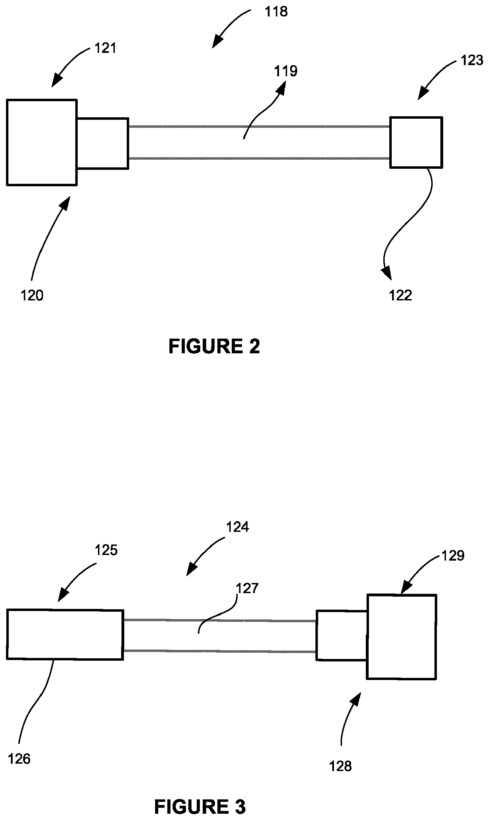

Adapters may be coupled to the PE couplings to provide a connection and accommodate any differences between the PE couplings of the PE subassembly 110A and the respective inlets and outlets of a rack supply and return manifold. With reference to FIGURE 2, which illustrates an example supply adapter removed from the cooling loop assembly 110, the supply adapter 118 may include an adapter supply line 119, which may be a pipe, a hose or the like that extends between a supply connector 120 at a first end 121 of the adapter 118 and a supply coupling 122 at a second end 123 of the adapter 118. An example return adapter, such as return adapter 124 shown in FIGURE 3, may similarly include a return connector 126 at a first end 125 of the return adapter 124, a return coupling 128 at a second end 129 of the return adapter 124, and an adapter return line 127 that extends between the return connector 126 and return coupling 128. In this example, supply connector 120 can be coupled to a liquid cooling supply source or manifold (not shown in this view) of a larger cooling system (see FIGURES 4-5) and return connector 126 may connect to a liquid cooling return or manifold (not shown in this view).

In this example, the supply and return adapters are shown as having different structural configurations. However, in other examples, a universal adapter with connectors configured to couple both a return and supply coupling can be provided that would allow for the return and supply adapter to be one in the same.

The supply connector 120, as well as the return connector 126 may be quick disconnect fittings that are designed to provide fast and easy connection and disconnection of lines to the respective supply source and return source. Examples of quick disconnect fittings can include snap type (*e.g.,* spring loaded ball latching), non-latching, double shut-off, and dry break quick disconnect fittings. Utilizing quick disconnect fittings can provide a greater pressure drop than simpler fittings. Further, quick disconnect fittings do not require the use of tools to assemble and disassemble. In other examples, different types of connectors may be utilized, such as quick connectors. In other examples, supply connector 120 and/or the return connector 126 may be traditional connectors that require use of a tool to attach and detach the connector from the respective rack manifold or the supply and return.

As shown in FIGURE 1, the adapter supply line 119 and board supply line 144 connect the supply connector 120 of the supply adapter 118 to the board supply manifold 150. Cooling liquid may be distributed across the circuit board 112 along a length of the board supply manifold 150. This enables cooling liquid to reach and be distributed to each of the cooling devices 130a, 130b, 130c, 130d. As shown, the board supply manifold 150 is positioned adjacent at least one of the edges of each of the cooling devices 130a, 130b, 130c, 130d. But, in other examples, the board supply manifold 150 can be positioned anywhere on the circuit board 112 and in any shape or size. Secondary supply lines 146a, 146b, 146c, 146d extend from the supply manifold 150 to the supply inlets 132a, 132b, 132c, 132d of each respective cooling device 130a, 130b, 130c, 130d.

A return line 148 and adapter return line 127 join the return connector 126 of the return adapter 124 to the board return manifold 152. The board return manifold 152 can run parallel to the board supply manifold 150 and in this example, extends along a length of the circuit board 112 and adjacent at least one edge of each of the cooling devices 130a, 130b, 130c, 130d. Secondary return lines 154a, 154b, 154c, 154d extend between the board return manifold 152 and each of the return outlets 134a, 134b, 134c, 134d of the respective cooling devices 130a, 130b, 130c, 130d.

The cooling devices 130a, 130b, 130c, 130d may be conventional liquid cooling devices, such as cold plates, heat sinks, or other devices that can be used in connection with liquid cooling of a chip or microelectronic assembly. The cooling devices 130a, 130b, 130c, 130d are shown having an identical configuration, but in other examples, one or more of the cooling devices 130a, 130b, 130c, 130d may differ. Further, the cooling devices 130a, 130b, 130c, 130d may be arranged in any configuration, and any number of cooling devices may be arranged on the system.

The cooling loop assembly 110 may continually pump cooling liquid through the supply adapter and supply lines, and heated return cooling liquid may be pumped through the return lines and return adapter. The cooling liquid may be any known cooling liquid from a continuous source of cooling liquids or a chiller system. Cooling liquid may include, for example, water, deionized water, inhibited glycol and water solutions, dielectric fluids, and any suitable cooling liquid.

During operation, cooling liquid from a primary source, such as a rack supply manifold 164 (see FIGURE 4), can enter the loop assembly 110 through supply of the loop assembly 110 at the supply connector 120 of adapter 118 in the direction A shown by the arrow. Incoming cooling liquid, which will be represented by a diagonal cross-hatching pattern in the examples described herein, will then be dispersed along the length L of the board supply manifold 150, and into each of the secondary supply lines 146a, 146b, 146c, 146d. The flow of cooling liquid will continue through each of the secondary supply lines 146a, 146b, 146c, 146d and into the supply inlets 132a, 132b, 132c, 132d of the respective cooling devices 130a, 130b, 130c, 130d. Heated surfaces of the cooling devices 130a, 130b, 130c, 130d will heat and increase the temperature of the cooling liquid. Heated return cooling liquid, which will be represented by square cross hatching in the examples described herein, exits each cooling device 130a, 130b, 130c, 130d through the respective cooling device return outlets 134a, 134b, 134c, 134d and flows to the board return manifold 152 through secondary return lines 154a, 154b, 154c, 154d. Heated return cooling liquid will be dispersed from the board return manifold 152 through return line 148 and adapter return line 127, which is connected to a primary return, such as a rack return manifold 166 (see FIGURE 4).

The supply adapter 118 and return adapter 124 can facilitate fast and easy coupling of the PE couplings to respective supply and return sources. For example, the system 100, which includes the PE subassembly 110A, may be purchased from a first company that has designed the PE subassembly 110A for that specific system 100. The PE couplings may be a generic set of couplings that may or may not be compatible with the supply and return connections on the rack manifold being used by the second company. When one or more of the PE couplings are not directly compatible with the respective supply and return connections of the second company, all or a part of the PE subassembly 110A must be completely redesigned to be compatible with the connections of the second company. This can require a great deal of time and effort to ensure a connection between the PE couplings with the connections of the second company. In a worstcase scenario, this requires taking up the entire network of hoses of the PE subassembly 110A designed by the first company and replacing them with a new set of hoses and connectors that are compatible with the second company. Using the return and supply adapters, however, allows for the system of the second company to be compatible with the connectors and manifold of the first company without the need for a redesign or great difficulty. For example, the second company may introduce an upgrade or new product that uses different connectors (size and/or type). Instead of having to replace each rack manifold and causing all machines and computing devices in a rack to be shut down, using return and supply adapters allows an operator to limit the required changes to a single tray level system that requires decoupling from the rack.

FIGURE 4 is a schematic view showing an example rack system 102 that further includes several computing systems or tray level systems housed within a device rack 162. Shelf 160 of computing device rack 162 houses system 100. For ease of discussion, system 100 will also be referred to herein as system A. Cooling loop assembly 110 of computing device 114 of system 100 is also shown, which further includes the supply adapter 118 and adapter supply line 119, return adapter 124 and adapter return line 127, and PE subassembly 110A. A plurality of other computing systems B-E, which include respective computing devices 114-1, 114-2, 114-3, 114-4, cooling loop assemblies 110-1, 110-2,110-3,110-4, supply adapters 118-1, 118-2, 118-3, 118-4 and return adapters 124-1, 124-2, 124-3, 124-4, all form part of the rack system 102 and are shown on respective shelves 160-1, 160-2, 160-3, 160-4 of computing device rack 162. Systems B-E can include the same features as System A and are not fully described for ease of discussion. In some examples, the computing devices 114, 114-1, 114-2, 114-3, 114-4 form a homogenous computing system where each of the individual computing systems on the rack 160 are identical and have identical PE cooling loop subassemblies 110A, 110A-1, 110A-2, 110A-3, 110A-4, with identical supply couplings 136, 136-1, 136-2, 136-3, 136-4 and PE return couplings 138,138-1, 138-2,138-3, 138-4. Additionally, systems B-E can include supply adapters 118-1, 118-2, 118-3, 118-4 with respective adapter supply lines 119-1, 119-2, 119-3, 119-4, and return adapters 124-1, 124-2, 124-3, 124-4 with respective adapter return lines 127-1, 127-2, 127-3, 127-4. In other examples, one or more of the overall systems A-E may differ, such that a heterogenous computing system is created. For example, computing devices 114, 114-1, 114-2, 114-3, 114-4 may differ from one another, along with the corresponding PE subassemblies 110A, 110A-1, 110A-2, 110A-3, 110A-4. Multiple supply and return connection points to the primary cooling liquid source and primary liquid return are shown along the rack supply manifold 164 and rack return manifold 166, as discussed further below. The rack 102 and systems A-E are shown in one arrangement, but any arrangement may be utilized, including greater or fewer number of systems on the rack.

A rack supply manifold 164 can extend the length of the computing device rack 162 and may be connected to a central cooling liquid supply line 168. Rack supply manifold 164 can distribute cooling liquid along the length of the entire rack and provide a source of cooling liquid to each cooling loop assembly 110, 110-1, 110-2, 110-3,110-4 of each respective computing device 114, 114-1, 114-2, 114-3,114-4. As shown, each system is connected to the rack supply manifold 164 at a supply inlet or connection point. For example, System A is coupled to rack supply manifold 164 at rack supply connection point or supply inlet connection 170a. Similarly, System B through System E are coupled to rack supply manifold 164 at respective rack supply connection points 170b, 170c, 170d, 170e. Connection points or manifold inlet connections 170a-170e may be supply inlets or openings to the rack supply manifold 164. In some examples, the connection points 170a-170e include a mechanism or mechanical fastener or the like, for coupling to each respective system A-E. In some examples, the supply connection points 170a - 170e may be threaded or include an interlocking means for mechanically attaching to the supply line of each respective system. In this example, the respective supply adapters 118, 118-1, 118-2, 118-3, 118-4 will connect with each of the respective supply connection points or supply inlet connections 170a, 170b, 170c, 170d, 170e, as discussed further below.

A rack return manifold 166 can similarly extend the length or overall height of the computing device rack 162, provide a return for heated cooling liquid returning from the system, and pump liquid out of the computing device rack 162 and into a central return line 169 to return heated cooling liquid to system source for cooling. Rack supply manifold 164 can distribute heated return cooling liquid along the length of the entire rack and provide a conduit for distributing heated cooling liquid to the primary return (not shown). As shown, each system A-E is connected to the rack return manifold 166 at a return inlet or connection point. For example, System A is coupled to rack return manifold 166 at rack return connection point or rack return connection 172a. Similarly, System B - System E are each coupled to rack return manifold 166 at respective rack return connections 172b, 172c, 172d, 172e. Similar to the supply connection points 170a-170e, rack return connection points 172a, 172b, 172c, 172d, 172e may be outlets or openings to the rack return manifold 166. In this example, the respective return adapters 124, 124-1, 124-2, 124-3, 124-4 will connect with each of the respective return connections 172a, 172b, 172c, 172d, 172e, as discussed further below.

The rack supply and rack return manifolds 164,166 extend along the sides of the rack, but in other examples, one or both rack supply and rack return manifolds can be positioned anywhere adjacent the computing device rack 162, including, for example, the front, rear, or same side of the server rack.

PE subassembly 110A of the cooling loop assembly 110 of computing device 114 is shown having a PE supply coupling 136 and a PE return coupling 138. Supply adapter 118 couples PE subassembly 110A with the rack supply connection point 170a. In this example, one end of the supply adapter 118 is coupled to PE supply coupling 136 via the adapter supply coupling 122. The other end of the supply adapter 118 is joined to the supply connection point 170a on the supply manifold 164 via the adapter supply connector 120.

Return adapter 124 couples PE subassembly 110A with rack return connection point or rack return connection 172a. In this example, one end of the return adapter 124 is coupled to PE return coupling 138 via the adapter return coupling 128. The return connector 126 at the other end of the return adapter 124 joins to the rack at return connection 172a.

Each of the remaining computing devices 114-1, 114-2, 114-3, 114-4 on the rack 162 have a respective cooling loop assembly 110-1, 110-2, 110-3, 110-4, including the respective supply adapter 118-1, 118-2, 118-3, 118-4, return adapter 124-1, 124-2, 124-3, 124-4, and PE subassembly 110A-1, 110A-2, 110A-3, 110A-4. Each PE subassembly has a respective PE supply coupling 136-1, 136-2, 136-3, 136-4 and a PE return coupling 138-1, 138-2, 138-3, 138-4. Supply adapters 118-1, 118-2, 118-3, 118-4 similarly couple each of the respective PE supply couplings 136-1, 136-2, 136-3, 136-4 to the respective rack supply connection points 170b, 170c, 170d, 170e. Return adapters 124-1, 124-2, 124-3, 124-4 couple each of the respective PE return couplings 138-1,138-2,138-3, 138-4 to the respective rack return connections 172b, 172c, 172d, 172e. As shown, a first end of each return adapter 124-1, 124-2, 124-3, 124-4 is connected to a respective PE return coupling 138-1, 138-2, 138-3, 138-4 via adapter return coupling 128-1, 128-2, 128-3, 128-4. A second end of each return adapter 124-1, 124-2, 124-3, 124-4 is connected to the respective rack return connections 172b, 172c, 172d, 172e via the return connector 126-1, 126-2, 126-3, 126-4.

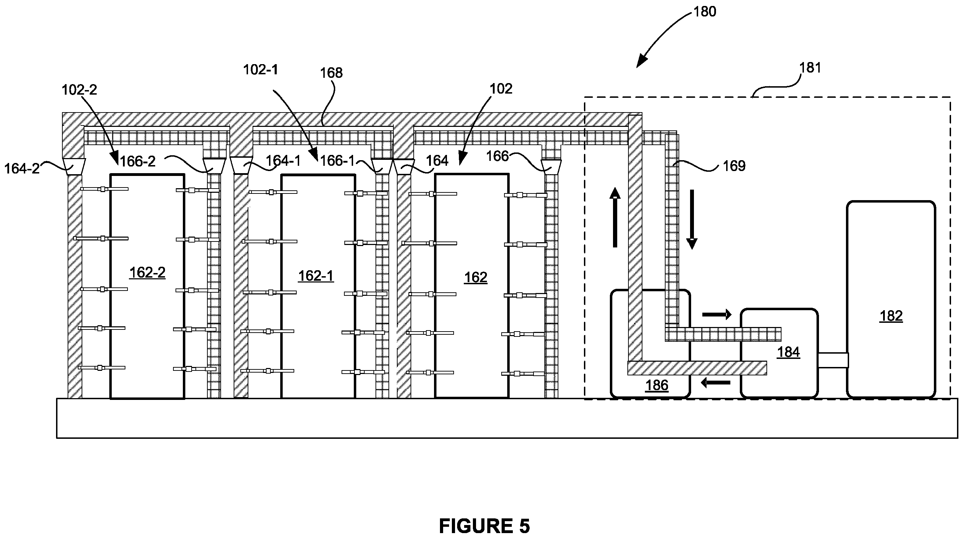

FIGURE 5 illustrates an example cooling system 180 that includes a plurality of rack systems. Rack system 102 is shown as one of a plurality of rack systems that form part of a cooling system 180. In this example, cooling system 180 may include any number of additional rack systems and in this example, further include rack systems 102-1, 102-2, which may be similar to rack system 102 and are not described again for ease of discussion. In other examples, rack system 102 may be a single data rack connected to at least one cooling system or may be one in a series of any number of racks forming part of the cooling system.

A water source 182 may pump liquid, such as water, into cooling unit 184. Cooling unit 184 can be any conventional cooling unit 184 capable of cooling water within the unit to a pre-set temperature. Water from cooling unit 184 will then be pumped into the central distribution unit 186, which will further pump and distribute cooling liquid through the central cooling liquid supply line 168 and into each of the rack supply manifolds 164, 164-1,164-2 and each first and second connector (not shown) of each computing device (not shown) in the respective computing device racks 162, 162-1, 162-2. Heated return cooling liquid will exit the respective computing device racks 162, 162-1, 162-2 through the respective rack return manifolds 166, 166-1, 166-2 and into the central cooling liquid return line 169 and back to the central distribution unit 186. The central distribution unit 186 will then pump the heated return cooling liquid into the cooling unit 184 where the heated return cooling liquid will be cooled and then circulated back into the central distribution unit 186 and pumped back into the system. It is to be appreciated that the central supply and return sub-system components 181 provide one method or configuration for cooling and distributing the cooling liquid into the central supply and return lines, but numerous other examples or configurations may be used to accomplish the same function. For example, the lines may run underground, additional or fewer cooling components may be used.

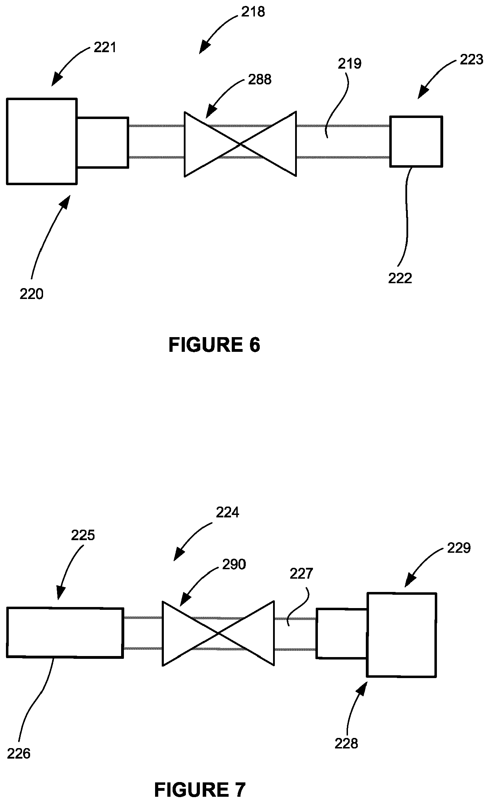

The supply adapter and return adapter provide a mechanism to allow an operator to quickly and easily attach several cooling loop subassemblies of individual systems housed in a rack to the rack supply manifold. The supply and return adapters can be modified to accommodate the differing PE loop subassemblies of the different computing systems. The supply and return adapters can also be further modified or enhanced to optimize operation of a cooling loop assembly. FIGURE 6 illustrates an example supply adapter 218 that includes a flow control device. The flow control device can be any device, mechanism, or sub-system to control flow rate, including without limitation valves, auxiliary pumps, combinations of valves and auxiliary pumps on the same or different adapter, or other devices or combinations of devices configured to limit the flow of liquid through the system.

In the example shown in FIGURE 6, the flow control device 288 may be a valve that has been incorporated into the adapter to regulate flow rate. The valve may be an actively adjustable valve, such as a manually operated valve and/or a fully or partially automated valve, such as a valve controlled by a computing device. The valve may also be a fixed flow restriction, such as an orifice. As in the previous example, the supply adapter 218 may also include an adapter supply line 219, which may be a pipe or hose or the like that extends between a supply connector 220 at a first end 221 and a supply coupling 222 at a second end 223 of the supply adapter 218. Supply line 219 will direct cooling liquid through the flow control device 288, which may be positioned along the adapter supply line 219. In other examples, the flow control device 288 may be positioned elsewhere on the supply adapter 218 and supply line 219 or other portion of the supply adapter may be configured to direct cooling liquid through the flow control device.

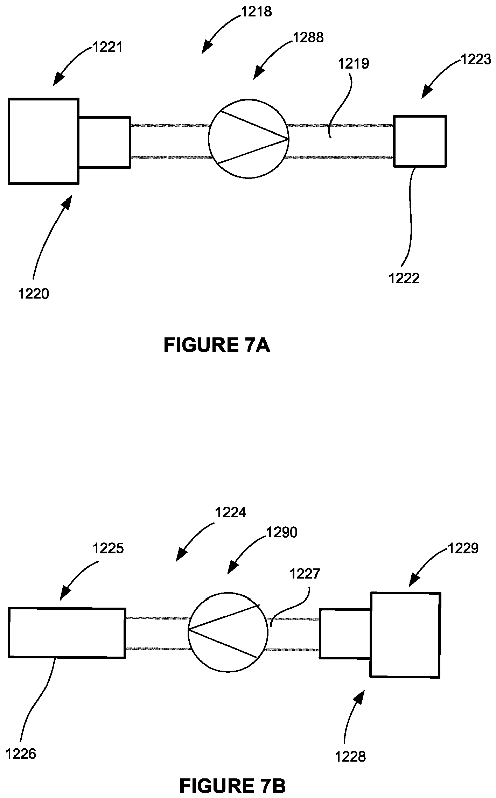

An example return adapter 224 is shown in FIGURE 7 that includes a flow control device 290 configured to control the rate of flow of fluid through the return adapter 224. Flow control device 290 can also control the flow rate of the fluid, such as heated fluid that leaves the cooling loop assembly of the tray level system to which the return adapter 224 is connected. The flow control device 290 may be positioned along the adapter return line 227, but in other examples, may be positioned elsewhere. The return adapter 224 may further include a return connector 226 at a first end 225 of the return adapter 224, a return coupling 228 at a second end 229 of the return adapter 224, and an adapter return line 227 that extends between the return connector 226 and return coupling 228. The adapter return line 227 will direct cooling liquid through the flow control device, but in other examples, another return line or device may be used to direct cooling liquid through the flow control device. In the example where the flow control device 290 is a valve, the valve may be the same or different than the valve of the supply adapter 218. Additionally, in other examples, only the supply adapter 218 may include a flow control device and the return adapter does not. In still other examples, the flow control device may additionally or alternatively be an auxiliary pump.

FIGURE 7A shows an alternative configuration, where the flow control device is an auxiliary pump. In contrast to a valve which restricts flow, the auxiliary pump can be used to push flow through the cooling system to regulate flow through the cooling loop and overall rack system. As shown, the flow control device 1288 may be an auxiliary pump that has been directly incorporated into the supply adapter to assist with regulating the flow rate. The pump may be any type of pump that can be used to move fluid and otherwise help to regulate liquid flow rate. Some non-limiting examples include a positive-displacement pump, a rotary lobe pump, progressive cavity pump, rotary gear pump, piston pump, gear pump, screw pump, peristative pump, plunger pump, velocity pump, rotodynamic pump, radial flow pump, rotary or reciprocating positive displacement pump, or any known pump. Similar to the previous example, the supply adapter 1218 may include an adapter supply line 1219, which may be a pipe or hose or the like that extends between a supply connector 1220 at a first end 1221 and a supply coupling 1222 at a second end 1223 of the supply adapter 1218. Supply line 1219 will direct cooling liquid through the flow control device 1288, which may be positioned along the adapter supply line 1219. In other examples, the flow control device 1288 may be positioned elsewhere on the supply adapter 1218 and supply line 1219 or other portion of the supply adapter may be configured to direct cooling liquid through the flow control device. In still other examples, the auxiliary pump may be positioned just prior to or just after the respective first and second ends 1221, 1223.

An example return adapter 1224 is shown in FIGURE 7B that includes a flow control device 1290 that controls the rate of flow of fluid through the return adapter 1224. Flow control device 1290 can also control the flow rate of the fluid, such as heated fluid that leaves the cooling loop assembly of the tray level system to which the return adapter 1224 is connected. The flow control device 1290 may be an auxiliary pump that is positioned along the adapter return line 1227, but in other examples, may be positioned elsewhere along or directly adjacent the return adapter 1224. The return adapter 1224 may further include a return connector 1226 at a first end 1225 of the return adapter 1224, a return coupling 1228 at a second end 1229 of the return adapter 1224, and an adapter return line 1227 that extends between the return connector 1226 and return coupling 1228. The adapter return line 1227 will direct cooling liquid through the flow control device, but in other examples, another return line or device may also or alternatively be used to direct cooling liquid through the flow control device.

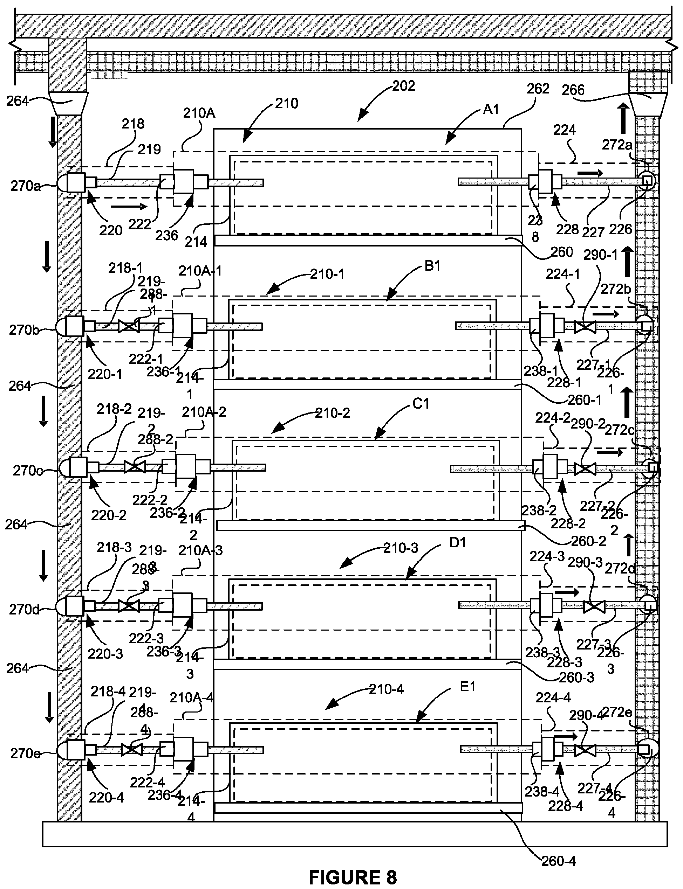

FIGURE 8 is a schematic view showing use of the supply adapter 218 and return adapter 224 in an example rack system 202 that houses multiple systems A1, B1, C1, D1, E1 on respective rack shelves 260, 260-1, 260-2, 260-3, 260-4. The only structural difference between systems A1-E1 of rack system 202 and System A (also system 100) through System E of rack system 102 of FIGURES 1-5 is that at least some of the supply and return adapters of systems within the rack further include flow control features to regulate the flow of cooling fluid into the cooling loop 210 and the flow of the heated liquid out of the cooling loop 210. The description of the features in FIGURES 1-5 is otherwise equally applicable here.

As in the previous examples, system A1 of rack system 202 includes a computing device 214 positioned on shelf 260 of computing device rack 262 and cooling loop assembly 210. Cooling loop assembly 210 further includes the supply adapter 218 without a flow control device, return adapter 224 without a flow control device, and PE subassembly 210A. PE subassembly 210A of the cooling loop assembly 210 of computing device 214 is shown having a PE supply coupling 236 and a PE return coupling 238. In other examples, one or both of the supply adapter 218 and return adapter 224 can include flow control devices.

Supply adapter 218 couples PE subassembly 210A with the rack supply connection point 270a. In this example, one end of the supply adapter 218 is coupled to PE supply coupling 236 via the adapter supply coupling 222. The other end of the supply adapter 218 is joined to the supply connection point 270a on the supply manifold 264 via the adapter supply connector 220.

Return adapter 224 connects PE subassembly 210A of system A1 with the rack return manifold 266. In this example, one end of the return adapter 224 is coupled to PE return coupling 238 via the adapter return coupling 228. The return connector 226 at the other end of the return adapter 224 is coupled to the rack return manifold 266 at return connection 272a.

Each remaining computing device 214-1, 214-2, 214-3, 214-4 on the rack 262 also includes a respective cooling loop assembly 210-1, 210-2, 210-3, 210-4, as well as a respective supply adapter 218-1, 218-2, 218-3, 218-4 with a respective flow control device 288-1, 288-2, 288-3, 288-4, a respective return adapter 224-1, 224-2, 224-3, 224-4 with respective return flow control devices 290-1, 290-2, 290-3, 290-4, and respective PE subassembly 210A-1, 210A-2, 210A-3, 210A-4. As in the previous examples, the flow control devices 288-1, 288-2, 288-3, 288-4 of the respective supply adapters 218-1, 218-2, 218-3, 218-4 may be positioned along the adapter supply lines 219-1, 219-2, 219-3, 219-4. Flow control devices 290-1, 290-2, 290-3, 290-4 of the return adapters 224-1, 224-2, 224-3, 224-4 may be positioned along the adapter return line 227-1, 227-2, 227-3, 227-4. In this example, the flow control devices 288-1, 288-2, 288-3, 288-4 of the supply adapters may be valves, but in other examples, one or more of the flow control devices of the supply adapters may instead be an auxiliary pump. Still further, the flow control devices 290-1, 290-2, 290-3, 290-4 of the return adapters 224-1, 224-2, 224-3, 224-4 may be valves, but in other examples, one or more of the flow control devices of the return adapters may be an auxiliary pump. In this regard, in any one cooling loop, a pump, a valve, or a combination of the two may be implemented in combination or tandem with the supply or return adapter to control flow through the cooling loop of each induvial system.

Each remaining PE subassembly can further include a respective PE supply coupling 236-1, 236-2, 236-3, 236-4 and a PE return coupling 238-1, 238-2, 238-3, 238-4. Supply adapters 218-1, 218-2, 218-3, 218-4 couple each of the remaining and corresponding PE supply couplings 236-1, 236-2, 236-3, 236-4 to the supply manifold 264. As shown, supply connectors 220-1, 220-2, 220-3, 220-4 couple one end of the supply adapters to the respective rack connection supply points 270b, 270c, 270d, 270e. Supply couplings 222-1, 222-2, 222-3, 222-4 are positioned at the other end of the respective supply adapters 218-1, 218-2, 218-3, 218-4 and directly couple to the corresponding PE supply couplings 236-1, 236-2, 236-3, 236-4.

Return adapters 224-1, 224-2, 224-3, 224-4 couple the respective PE subassemblies 210A-1, 210A-2, 210A-3, 210A-4 to the return manifold 266. As shown, PE return couplings 238-1, 238-2, 238-3, 238-4 of the PE subassemblies 210A-1, 210A-2, 210A-3, 210A-4 are coupled to the adapter return couplings 228-1, 228-2, 228-3, 228-4 on one end of the respective return adapters 224-1, 224-2, 224-3, 224-4. Return connectors 226-1, 226-2, 226-3, 226-4 at the other end of the respective return adapters 224-1, 224-2, 224-3, 224-4 couple to the respective rack connection return points 270b, 270c, 270d, 270e on the return manifold 266.

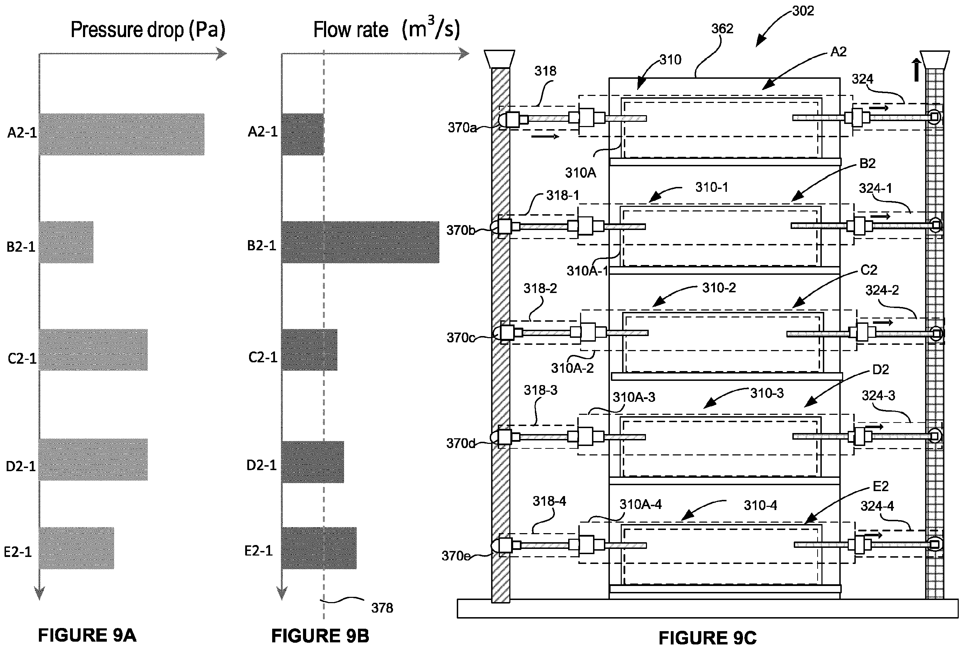

Providing at least some of the adapters in the rack with flow control devices can help to provide for more efficient cooling of the system by helping to regulate a more constant flow of cooling liquid throughout the rack supply and return manifolds and individual cooling loop assemblies. The improvements resulting from the addition of flow control devices to the adapters can be seen when comparing the pressure and flow profiles for rack systems utilizing the adapter alone and the adapter with flow control device, as illustrated in the comparison between FIGURES 9A-9C (rack systems with adapters having no flow control devices) and 10A-10C (rack system with at least one adapter having a flow control devices).

Referring first to FIGURES 9A-9C, a schematic diagram is shown in FIGURE 9C of a rack system 302, which is identical to rack system 102 previously described with regard to FIGURES 1-6 and includes the same features. FIGURE 9A illustrates a corresponding pressure drop chart and FIGURE 9B illustrates a corresponding flow rate chart. Each cooling loop assembly 310, 310-1, 310-2, 310-3, 310-4 further includes a respective supply adapter 318, 318-1, 318-2, 318-3, 318-4; a respective return adapter 324, 324-1, 324-2, 324-3, 324-4; and a respective pre-existing cooling loop assembly 310A, 310A-1, 310A-2, 310A-3, 310A-4.

In this example, the system 302 is a heterogeneous system comprised of different computing device systems A2-E2, each system having a computing device and a respective and corresponding cooling loop assembly 310, 310-1, 310-2, 310-3, 310-4. At least one or more of the individual systems A2-E2 may differ from others in the rack and require more or less flow rate to cool the individual system, and also have a unique pressure drop specific to each system. Pressure drop and flow rate are proportional to one another. Pressure drop is the change or drop in pressure at each inlet because of the system demand and is determined by determining the difference between the pressure at the supply inlet and the pressure at the return outlet. A higher liquid flow rate through the manifold inlets or connections results in a greater pressure drop. Conversely, a lower rate of liquid flow through the manifold outlet or connections results in a lower pressure drop.

The pressure drop chart of FIGURE 9A and the flow chart of FIGURE 9B schematically illustrate an example relationship between the flow rate and pressure drop in the rack system 302. In this example, pressure drop can be measured for each system A2-E2 based on the pressure determined at the respective manifold supply inlet 370a, 370b, 370c, 370d, 370e and the corresponding manifold return outlet 372a, 372b, 372c, 372d, 3702e. In one example, the pressure drop is measured as the difference between the rack manifold supply inlet 370a, 370b, 370c, 370d, 370e and the corresponding rack return outlet 372a, 372b, 372c, 372d, 372e of each respective computing system A2, B2, C2, D2, E2.

The flow rate chart of FIGURE 9B schematically illustrates the differences in flow rate required to cool each individual system A2-E2. The minimum amount of flow rate 378 required to cool system A2 is represented by line 378 and represents the minimum flow rate that must flow through the system 302 to achieve cooling of system A2. The flow rate chart indicates that each of the remaining systems B2-E2 requires more than this minimum flow rate 378 to achieve cooling of the individual systems. As shown, the pressure drop in system A2 is greater than the pressure drop in systems B2-E2. The rate of liquid flow through systems B2, C2, D2, E2 shown in the flow chart indicate that the flow rate for these individual systems is greater than the minimum flow rate 378 so as to accommodate the individual and unique requirements of the different systems A2-E2 Similarly, the corresponding pressure drops also vary. The lack of uniformity in flow rate and pressure drop in the rack system 302 results in the need for more power and energy to produce increased flow rates in each of the systems B2-E2, which also results in overcooling of some systems, increased cost, and reduced operating efficiency (as will be discussed below).

Optimizing the flow distribution across a rack system can help to avoid overcooling individual systems, which saves pump power. Determining what constitutes optimal flow distribution for a rack system can depend on the needs of an individual system, the particular rack system and/or the overall cooling system. Some rack systems may require a more uniform flow rate among the different tray level systems to achieve optimal flow distribution, but other rack systems may require a non-uniform flow rate among the different systems. Use of adapters with flow control devices, such as valves and/or pumps and the like, provides an operator with the ability to customize the flow rates in individual tray level systems to achieve an overall more uniform or non-uniform flow rate in a rack system or overall cooling system, as needed.

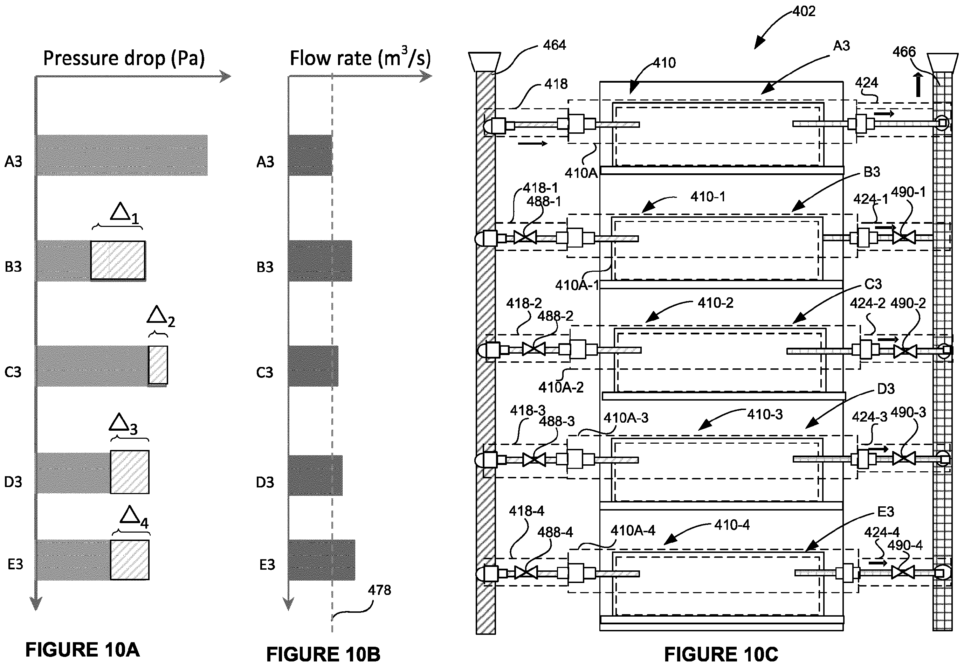

In one example, optimal flow distribution throughout a rack system requires a more uniform flow of liquid among each of the individual systems within the rack system, which can be accomplished through the use of adapters with flow control devices. This optimized flow distribution may result from the individual needs of the different types of computing systems at each tray level, such that achieving a more uniform pressure drop and flow of liquid among the different systems can prevent significant overcooling of any one individual system. FIGURE 10C is a schematic diagram of a rack system 402, which is identical to rack system 202 previously described with regard to FIGURE 8 and includes the same features. For ease of discussion, the features will not be repeated or discussed at length. A corresponding pressure drop chart is shown in FIGURE 10A and a corresponding flow rate chart is illustrated in FIGURE 10B.

As in the previous examples, the rack system 402 includes a plurality of server tray level systems A3, B3, C3, D3, E3 each having a cooling loop assembly 410, 410-1, 410-2, 410-3, 410-4 connected to a rack manifold 464 and supply manifold 466. System A3 includes a supply adapter 418, with no control device, a return adapter 424, with no control device, and a PE subassembly 410A. Systems B3, C3, D3, E3 include respective supply adapters 418-1, 418-2, 418-3, 418-4 with respective flow control devices 488-1, 488-2, 488-3, 488-4, return adapters 424-1, 424-2, 424-3, 424-4 with respective flow control devices 490-1, 490-2, 490-3, 490-4, and PE subassemblies 410A-1, 410A-2, 410A-3, 410A-4.

Incorporating flow control devices into the adapters for use with rack system 402 allows a system operator to customize the pressure drop and flow rate at each of the server tray level systems. In this example, the pressure drop can be purposefully increased at one or more of respective server tray level systems B3, C3, D3, E3, which will allow for a more optimized flow rate tailored to meet the needs of each of the individual server tray level systems A3, B3, C3, D3, E3. For example, as shown, incorporating at least one or more supply and return adapters with flow control devices into the cooling loops 410-1, 410-2, 410-3, 410-4 of respective systems B3, C3, D3, E3 can help to regulate fluid flow rate through every respective cooling loop 410, 410-1, 410-2, 410-3, 410-4 in the rack system 402. In one example, liquid flow through system A3 is unrestricted through both the supply adapter 418 and return adapter 424 (neither of which, in this example, include flow control devices). Pressure drop in each of systems B3, C3, D3, E3 can then be modified, either increased or decreased, to regulate the fluid flow in each of these systems. An operator can modify the pressure drop by adjusting the flow control devices 488-1, 488-2, 488-3, 488-4 on the respective supply adapters 418-1, 418-2, 418-3, 418-4 and/or the flow control devices 490-1, 490-2, 490-3, 490-4 on the respective return adapters 424-1, 424-2, 424-3, 424-4. In this example, pressure drop is increased in each of systems B3, C3, D3, E3 by a respective amount △ ₁, △₂, △₃, △₄. These increases in pressure drop can directly impact the flow rate, which in this example, allows for a more uniform flow rate through all of the individual systems A3, B3, C3, D3, E3 in the rack system 402. For example, this uniformity is schematically shown in FIGURE 10B, where each of the individual flow rates for the board systems A3, B3, C3, D3, E3 are shown being closer to the minimum flow rate 478 required to achieve cooling in each system, as compared to a system that does not use a flow control device (e.g., FIGURES 9A-9C). In this example, the flow control devices 488-1, 488-2, 488-3, 488-4 on the respective supply adapters 418-1, 418-2, 418-3, 418-4 and the flow control devices 490-1, 490-2, 490-3, 490-4 on the respective return adapters 424-1, 424-2, 424-3, 424-4 are valves, but in other examples, the flow control devices of the return and/or supply adapters may instead all be auxiliary pumps and/or one or more of the cooling loops in a rack system may adopt a valve as a flow control device and one or more of the cooling loops in the rack system may be auxiliary pumps.

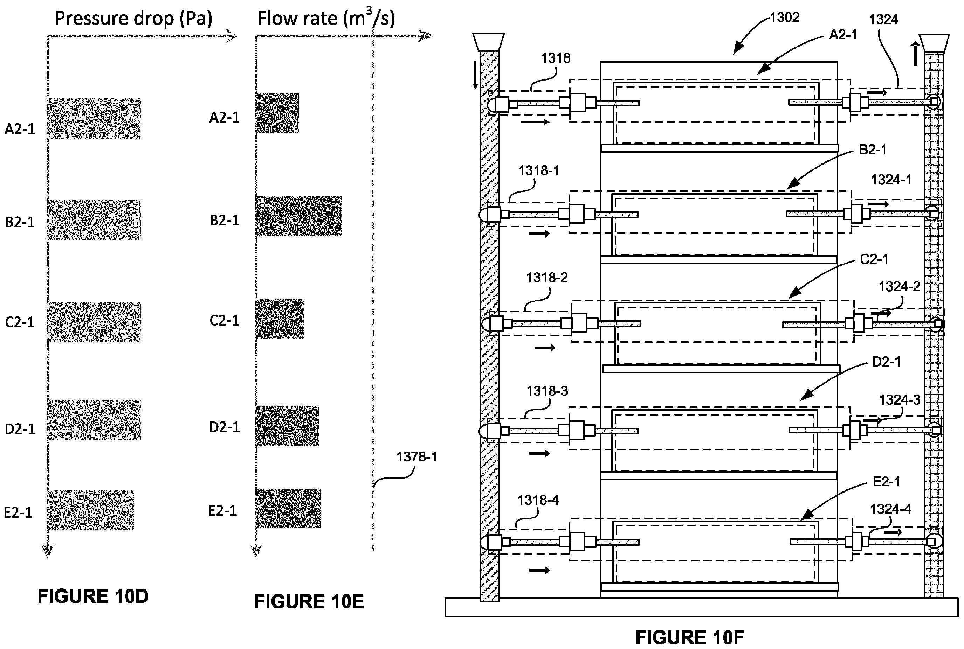

In other examples, optimizing the flow rate in the rack system may instead require achieving a more non-uniform flow rate distribution among the different systems. For example, as shown in FIGURES 10D-10F, another heterogenous rack system 1302 is illustrated. This example includes the same components as the components in the rack system 302 of FIGURE 9C and will not be described again in detail for ease of discussion. As in FIGURE 9C, supply adapters 1318, 1318-1, 1318-2, 1318-3, 1318-4 and return adapters 1324, 1324-1, 1324-2, 1324-3, 1324-4 of systems A2-1, B2-1, C2-1, D2-1, E2-1 do not include flow control devices. The only differences between the example rack system 302 of FIGURE 9C and the rack system 1302 of FIGURE 10F concerns the flow rates required to achieve optimal cooling of the respective rack systems. The minimum flow rate required to achieve cooling of the system A2-1 of rack system 1302 is represented by line 1378-1 in FIGURE 10E. As shown, the minimum flow rate of system A2-1 is significantly higher than the minimum flow rate required to achieve cooling of example rack system 302 of FIGURE 9C, as represented by line 378 in FIGURE 9B. The minimum flow rate required to achieve cooling of system A2-1 is also significantly higher than the minimum flow rates required to cool any one of systems B2-1, C2-1, D2-1, E2-1.

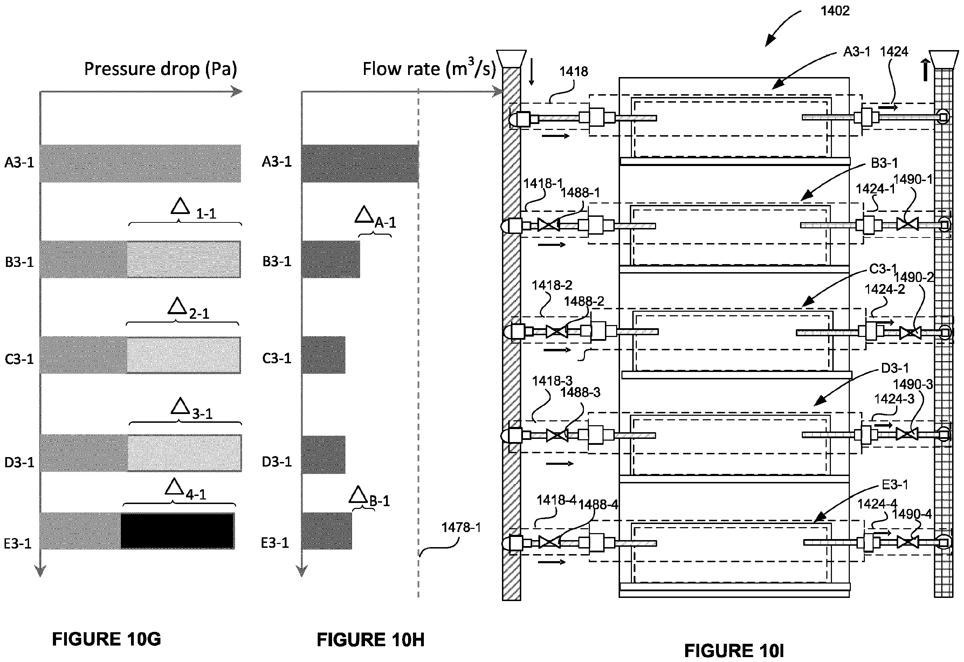

To increase the flow rate through system A2-1 of rack system 1302, such that the minimum flow rate can be achieved through system A2-1, the flow rate through system A2-1 must be modified. This can be achieved by limiting or reducing the flow rate of liquid coolant through one or more systems in the rack system, which can result in an increase of flow rate through other systems in the rack system. FIGURE 10I illustrates an example rack system 1402 that incorporates return and supply adapters, some of which include flow control devices that allow for modification of individual systems within the rack system 1402. FIGURE 10G illustrates a corresponding pressure drop chart and FIGURE 10H illustrates a corresponding flow rate chart. Rack system 1402 is otherwise structurally identical to system 402 of FIGURE 10C and the components will not be described again for ease of discussion. Incorporating flow control devices 1488-1, 1488-2, 1488-3, 1488-4 into the respective supply adapters 1418-1, 1418-2, 1418-3, 1418-4, as well as flow control devices 1490-1, 1490-2, 1490-3, 1490-4, into the respective return adapters 1424-1, 1424-2, 1424-3, 1424-4 with respective computing systems B3-1, C3-1, D3-1, E3-1 allows for greater control over the flow rate throughout the entire system. In this example, the flow control devices 1488-1, 1488-2, 1488-3, 1488-4, 1490-1, 1490-2, 1490-3, 1490-4 are valves, but other types of flow control devices may also be implemented.

Flow rate to system A3-1 must be increased to meet the minimum flow rate necessary to ensure cooling of system A3-1. In this example, decreasing the flow rate through one or more of systems B3-1, C3-1, D3-1, and E3-1 can result in an increase in flow rate to system A3-1. As shown in FIGURE 10H, the flow rate through system B3-1 is reduced by an amount △_{A-1} and the flow rate through system E3-1 is reduced by an amount △_{B-1}. Restricting the flow rate through systems B3-1 and system E3-1 leads to significant pressure increases in systems B3-1, C3-1, D3-1, and E3-1 by respective amounts △₁₋₁, △₂₋₁, △₃₋₁, △₄₋₁, as shown in FIGURE 10G. These changes help to increase the flow rate through system A3-1 to meet the minimum flow rate required for cooling of system A3-1. As shown in FIG. 10H, flow rate throughout the rack system 1402 can be considered non-uniform due to the significant difference in flow rate required to cool system A3-1, as compared to systems B3-1, C3-1, D3-1, E3-1.

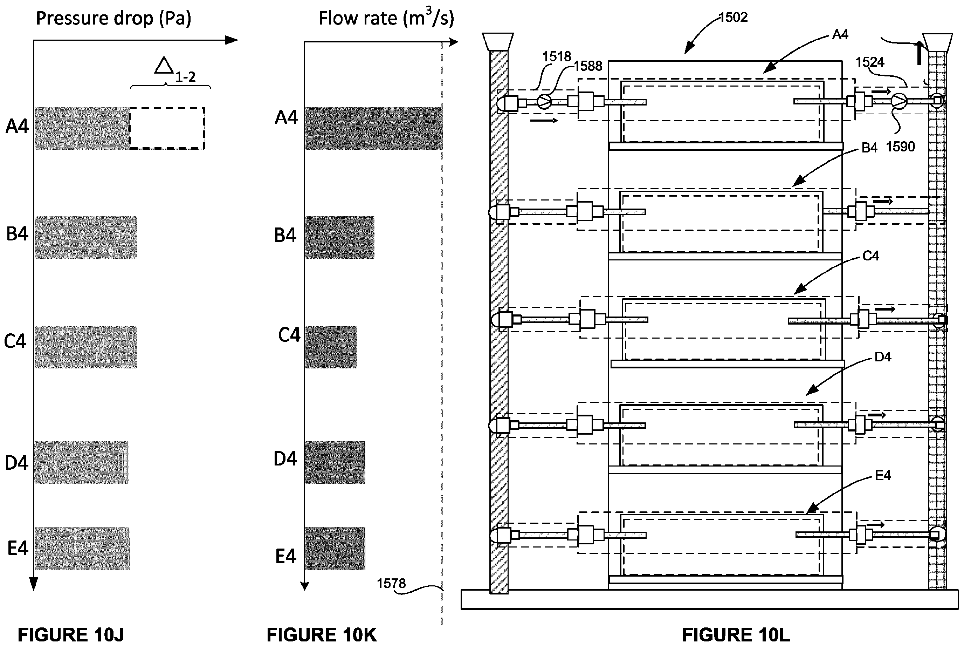

With reference back to the example of FIGS. 10D-10F, as an alternative to using supply and return adapters with valves to modify the flow rate through the first system A2-1 in the rack system 1302, one or more of the supply and/or return adapters may include pumps. FIGURES 10J-10L illustrate an example in which auxiliary pumps are implemented within a rack system, where FIGURE 10L illustrates an example rack system 1502, FIGURE 10J illustrates a corresponding pressure drop chart, and FIGURE 10K illustrates a corresponding flow rate chart. Rack system 1502 that is otherwise identical to rack system 1302-1 of FIGURE 10F and the components will not be described again for ease of discussion. The structural difference between rack system 1502 and rack system 1302 is that the first system A4 in rack system 1502 includes a supply adapter 1518 with a flow control device 1588 and the return adapter 1524 includes a flow control device 1590. In this example, the flow control devices 1588, 1590 are auxiliary pumps. None of the other return or supply adapters in the rack system include flow control devices.

As shown in FIGURE 10K, the minimum flow rate necessary to cool system A4 is represented by line 1578. Auxiliary pumps 1588, 1590 in the respective supply and return adapters 1518, 1524 can be configured to push and draw fluid through the system A4. The auxiliary pumps 1588, 1590 can be configured to increase the flow rate of liquid flowing through system A4 by an amount sufficient for the overall flow rate to meet the minimum flow rate required to cool system A4. This can also cause an increase in pressure drop in system A4 by an amount △₁₋₂, as shown in FIGURE 10J. The flow rate through the remainder of systems B4, C4, D4, E4 in rack system 1502 otherwise remains unchanged in this example.

Flow rate in a multi-rack system can also be regulated and improved by implementing adapters with flow control devices within one or more of the individual rack systems in the multi-rack system. In a multi-rack liquid cooling system, there may be a maldistribution of flow rate between each rack. The rack system that requires the least amount of flow rate to achieve cooling determines how much power is consumed at the CDU because enough liquid in the system must be supplied to this rack, which in many cases is the rack furthest away from the CDU. This can result in a flow rate that is unnecessarily higher at racks closest to the CDU, to ensure the proper liquid flow rate to the rack furthest away from the CDU. Implementing adapters with flow control devices can help to provide for a more consistent flow across all of the racks in the multi-rack system.

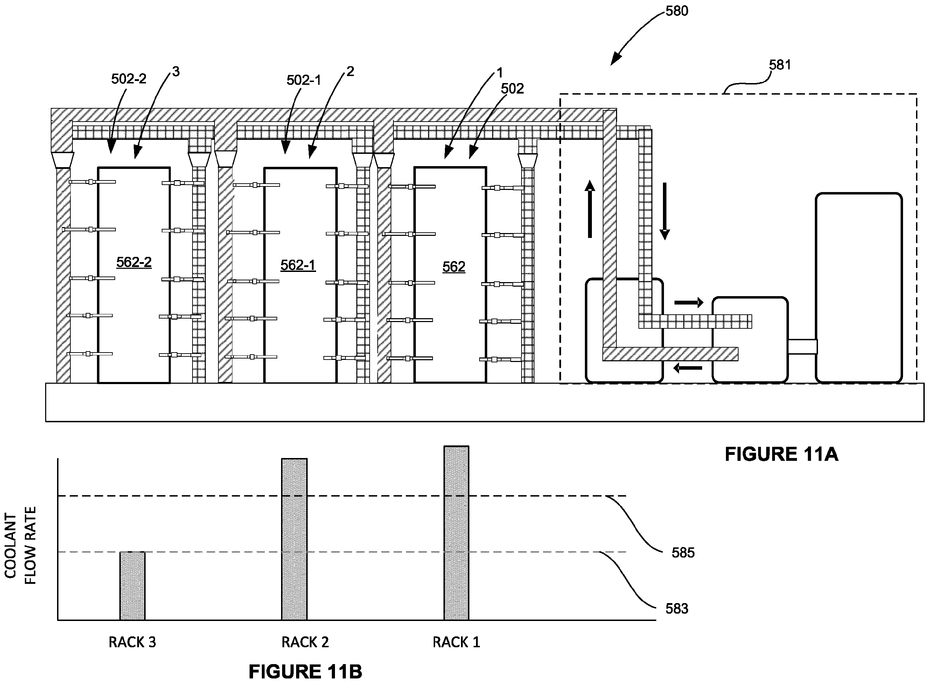

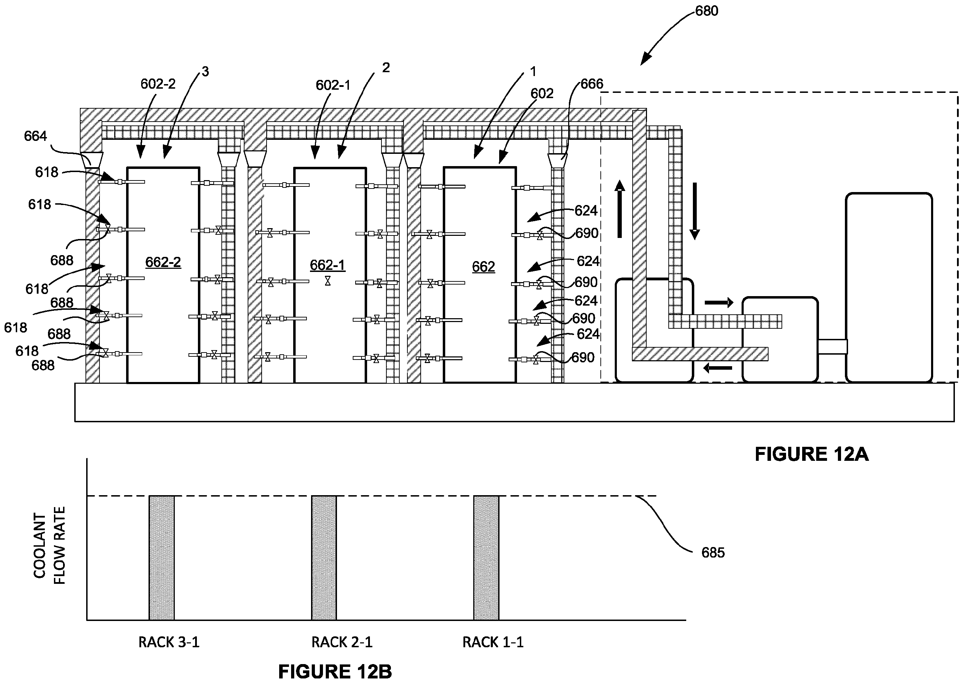

Differences in the overall flow rate across a system of racks that utilizes adapters with flow control devices, as compared to adapters without flow control devices are illustrated. FIGURES 11A-11B illustrate a system of racks that utilizes adapters without flow control devices, as compared to FIGURES 12A-12B, which illustrate a system of racks that utilize at least one or more adapters with flow control devices. Turning first to FIGURE 11A, a schematic cooling system 580 is illustrated, which is identical to FIGURE 5 and includes the same components, including multiple rack systems 502, 502-1, 502-2 (also referred to herein for ease of discussion and illustration as respective Rack Systems 1, 2, 3) that include respective racks 562, 562-1, 562-2. Each of the Rack Systems 1, 2, 3 houses a plurality of server tray level systems that include adapters (without further flow control devices) and central supply and return sub-system components 581. In this example, rack system 502-2 requires the lowest flow rate to achieve cooling of the server tray level systems (not shown) within the rack 562-2, as represented by line 583 shown in FIGURE 11B. This means that the average flow rate necessary to achieve cooling across all of the Rack Systems 1, 2, 3 in the overall cooling system 580 is represented by line 585. As shown, Racks 2 and 3 require an excessive flow rate well above the average flow rate 585 in order to ensure that the required flow rate to Rack 3 can be achieved.

FIGURES 12A-12B illustrate another schematic cooling system 680, which is otherwise similar to the cooling system 580 represented in FIGURE 11A, except that each of the rack systems 602, 602-1, 602-2, also referred to herein as respective Rack Systems 1-1, 2-1, 3-1, further house a plurality of server tray level systems that incorporate supply adapters 618 with flow control devices 688, as well as return adapters 624 with flow control devices 690. The supply adapters 618, including those with flow control devices 688, can be coupled to a rack supply manifold 664. The return adapters 624, including those with flow control devices 690, may be coupled to return manifold 666. For ease of illustration, only supply adapters 618, including those with flow control devices 688 have been identified in FIGURE 12A in relation to Rack System 3-1, and the return adapters 624, including those with flow control devices 690 are identified in relation to Rack System 1-1. However, it is to be understood that although not required, in this example, each rack includes return and supply adapters with (or without) flow control devices. Further, flow control devices can include but are not limited to valves and auxiliary pumps.

Implementing flow control devices into each of the Rack Systems 1-1, 2-1, 3-1 provides a mechanism for an operator to adjust the flow rate for each individual rack. In one example, the supply adapters 618 with flow control devices 688 and return adapters 624 with flow control devices 690 in Rack Systems 1-1 and 2-1 may be adjusted to restrict liquid flow, whereas the supply adapters 618 with flow control devices 688 and return adapters 624 with flow control devices 690 in Rack Systems 3-1 may be less restricted so as to allow for an increased liquid flow to Rack System 3-1 and in some examples, no restrictions may be placed on flow through Rack System 3-1. In one example, as illustrated in FIGURE 12B, Rack Systems 1-1 and 2-1 may be adjusted to flow at the average flow rate represented by line 685, and the Rack System 3-3 flow rate can be adjusted (to the extent required) so that the flow rate is increased to the average flow rate. (*See* FIGURES 11A-11B for comparison.) This results in a more uniform flow rate throughout Rack Systems 1-1, 2-2, and 3-2, which allows for optimization of the cooling system 680, which can include reduced power due to minimized overcooling and cost savings.

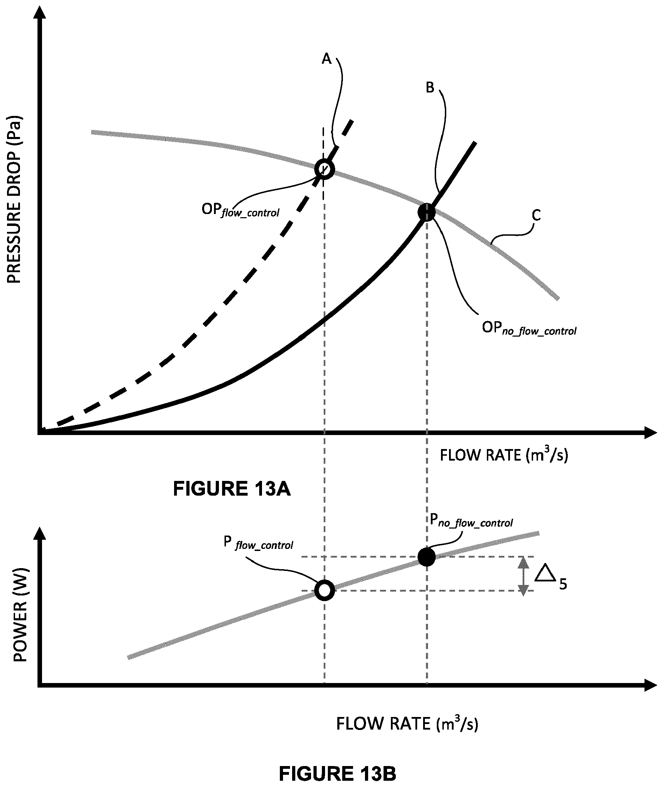

FIGURES 13A-13B illustrate how optimizing flow distribution at the server level in a rack system can save on pumping power and overall cost. FIGURE 13A illustrates pressure drop versus flow rate and compares a rack system that utilizes adapters with flow control device versus a system that only utilizes adapters without flow control devices . Curve A represents the pressure drop (Pascals) to fluid flow rate distribution for a system that utilizes an adapter with one or more flow control device, such as rack system 202 illustrated in FIGURE 8. Curve B represents the pressure drop to fluid flow rate for a system that only utilizes adapters with no flow control device, such as rack system 102 illustrated in FIGURE 4. Curve C is the pumping curve which intersects with Curve A at point OP_{flow_control} and Curve B at point OP_{no_flow_control}. Point OP_{flow_control} and Point OP_{no_flow_control} illustrate where the respective systems are operating to achieve cooling of the system. As shown, a higher pressure drop and flow rate can be achieved for a system utilizing supply and return adapters with flow control devices, as compared to a system that does not utilize a flow control device. FIGURE 13B further illustrates power consumption (Watts) relative to flow rate in the two systems. As shown, Point P_{flow_control} represents the power needed to cool a system using supply and return adapters with flow control devices. Point P_{no_flow_control} represents the power needed to col a system using only supply and return adapters that do not include flow control devices. Less power is required to achieve the flow rate of Curve A, as compared to Curve B. This results in an overall reduction in power consumption by an amount △₅, which can lead to a reduction in cost.

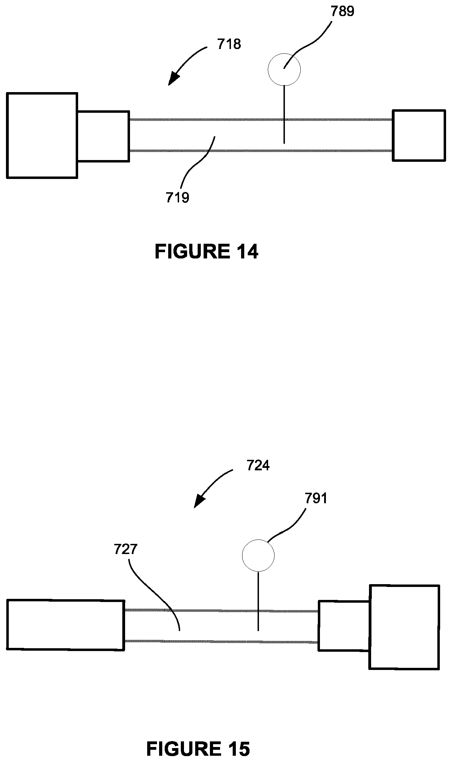

The adapters can be modified to incorporate additional features to further improve flow rate distribution and optimization of the system as a whole. FIGURE 14 illustrates a supply adapter 718 that is otherwise similar to supply adapter 118 of FIGURE 2 and includes the same features, which will not be reproduced or discussed for ease of discussion. FIGURE 15 similarly illustrates a return adapter 724 that is otherwise similar to return adapter 124 of FIGURE 3 and includes the same features. The only difference with the prior versions is that the return and supply adapters 718, 724 can further include a monitoring device or check point for monitoring characteristics of the system, such as temperature, pressure, flow rate, chemistry, and the like. An example supply monitoring device 789 is illustrated on the supply line 719, and an example return monitoring device 791 is illustrated on the return line 727. The monitoring devices 789, 791 can be any mechanism that will enable monitoring and/or control of features in the system, such as a sensor, including a sensor that determines flow rate and/or a screen that provides characteristics of the system.

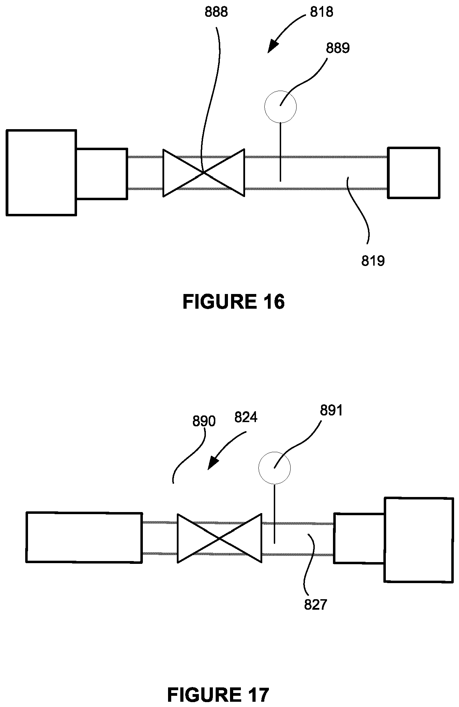

The monitoring system can be used in connection with a flow control device. For example, as shown in FIGURE 16, the supply adapter 818 can include both a supply monitoring device 889 and a flow control device 888. In this example, both the supply monitoring device 889 and flow control device 888 are positioned along the supply line 819, but in other examples, one or both may be positioned elsewhere. Similarly, as shown in FIGURE 17, the return adapter 824 can include both a return monitoring device 890 and a flow control device 891. Both the return monitoring device 890 and flow control device 891 are shown positioned along the return line 827, but in other examples, one or both may be positioned elsewhere. These monitoring devices 889, 890 can be used together with the flow control devices 888 and 891 to monitor and regulate liquid flow through the system.

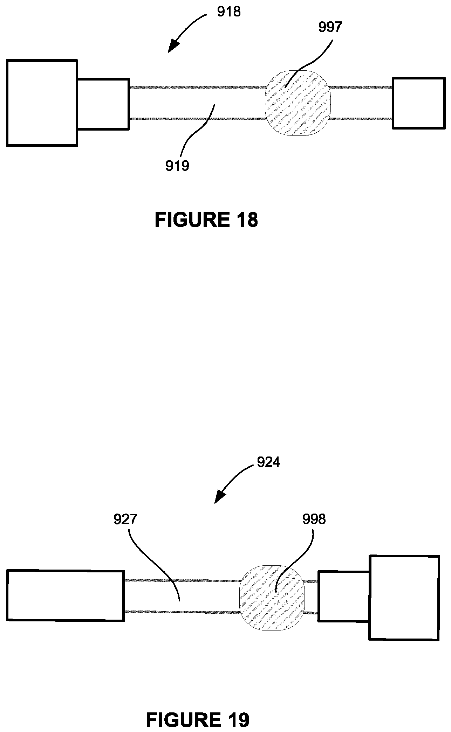

FIGURES 18-19 illustrate another example modification and/or addition to the return and supply adapters. The supply adapter 918 can include a filter 997 positioned along the respective supply line 919 and the return adapter 924 may include a filter 998 positioned along the return line 927. But, in other examples, the filter 998 may be positioned elsewhere. The addition of a filter can allow for a larger micron rating of facility level filter to meet the need of the majority of system, which saves energy and is easier to maintain. For special systems that require a finer filtration, the filter can be installed within the adapter system.

According to an aspect of the disclosure, an adapter for coupling a liquid cooling loop subassembly of a computing system to a device rack manifold includes a main body, a first connector, a second connector and a flow control device. The first connector is disposed on the main body and couples the adapter to a coupling of the liquid cooling loop subassembly. The second connector is disposed on the main body and couples the adapter to the device rack manifold. The flow control device is disposed between the first and second connectors and is configured to regulate a flow rate of liquid coolant through the liquid cooling loop subassembly; and/or
the main body comprises a hose, and the first connector is positioned at one end of the hose and the second connector is positioned at an opposed end of the hose; and/or
the first connector interlocks with the coupling of the liquid cooling subassembly and the second connector interlocks with the device rack manifold; and/or
the coupling of the liquid cooling subassembly is one of a supply coupling and a return coupling; and/or
when the coupling of the liquid cooling subassembly is a supply coupling, the device rack manifold comprises a supply manifold, and the first connector couples the adapter to a supply coupling of the liquid cooling subassembly and the second connector couples the adapter to a supply inlet connection of the supply manifold; and/or
when the coupling of the liquid cooling subassembly is a return coupling, the device rack manifold is a return manifold, and the first connector couples the adapter to a return coupling of the liquid cooling subassembly and the second connector couples the adapter to a return outlet connection of the return manifold; and/or
the supply inlet connection has a first configuration and the supply coupling has a second configuration that is incompatible with the first configuration, such that the supply coupling is unable to directly connect with the supply inlet connection.; and/or
the return outlet has a first configuration and the return coupling has a second configuration that is incompatible with the first configuration, such that the return coupling is unable to directly connect with the return outlet connection of the return manifold; and/or
the flow control device comprises at least one of a valve and a pump; and/or
the adapter further comprises at least one of a monitoring device and a filter; and/or
the monitoring device is coupled to the main body, the monitoring device being configured to provide characteristics about the flow rate through the rack manifold; and/or
the filter is coupled to the main body, the filter being configured to filter particulate matter in cooling liquid flowing through the adapter.

According to another aspect of the disclosure, a device rack system includes a supply manifold, a return manifold, a plurality of supply adapters, and a plurality of return adapters. The supply manifold has a plurality of supply inlet connections configured to distribute a cooling liquid. The return manifold has a plurality of return outlet connections configured to receive the cooling liquid. The plurality of supply adapters each have a supply adapter manifold connection configured to connect with a corresponding one of the supply inlet connections and a supply coupling configured to couple with a corresponding cooling liquid subassembly. The plurality of return adapters each have a return adapter manifold connection configured to connect with a corresponding one of the return outlet connections; and/or
at least some of the plurality of supply adapters further comprise a flow control device to regulate a flow rate of the cooling liquid; and/or
at least some of the plurality of return adapters further comprise a flow control device to regulate a flow rate of the cooling liquid; and/or
the plurality of supply adapters each further comprise a hose with the supply adapter manifold connection at one end and the supply coupling at an opposed end, the supply adapter manifold connection interlocking with a corresponding one of the supply inlet connections; and/or
the plurality of return adapters further comprise a return coupling configured to couple with the corresponding cooling liquid subassembly, wherein the plurality of return adapters each further comprise a hose with the return adapter manifold connection at one end of the hose and the return coupling positioned at an opposed end, the return adapter manifold connection interlocking with a corresponding one of the return outlet connections; and/or
the rack system further includes a plurality of computing systems, a a plurality of server tray shelves for housing computing systems; and a plurality of cooling loop assemblies for cooling the plurality of computing systems. Each cooling loop assembly corresponds to one of the server tray shelves and comprises one of the plurality of supply adapters; one of the plurality of return adapters; and one of the cooling loop subassemblies; and/or
at least some of the supply adapters further comprising a main body having a monitoring device coupled to the main body, the monitoring device being configured to provide characteristics about flow rate of the cooling liquid through the at least some fo the supply adapters; and/or
at least some of the supply adapters further comprise a main body having a filter coupled to the main body, the filter being configured to filter particulate matter in cooling liquid flowing through the at least some of the adapters.

According to another aspect of the disclosure, a method for cooling a computing system in a device rack comprises attaching a cooling loop assembly configured to cool components of the computing system to the device rack. The attaching further comprises: connecting a first connector of a supply adapter to a manifold supply inlet of a supply manifold for cooling liquid; connecting a second connector of the supply adapter to a supply coupling of a pre-existing cooling loop subassembly; connecting a first connector of a return adapter to a manifold return outlet of a return manifold configured to receive heating cooling liquid; and connecting a second connector of the return adapter to a return coupling of the pre-existing cooling loop subassembly; and/or further regulating a flow rate of cooling liquid flowing through the supply adapter by directing fluid into a fluid control device within the supply adapter.

According to another aspect of the disclosure, an adapter for coupling a liquid cooling loop subassembly of a computing system to a device rack manifold includes a main body, a first connector disposed on the main body, a second connector disposed on the main body, and a flow control device disposed between the first and second connectors. The first connector couples the adapter to a coupling of the liquid cooling loop subassembly. The second connector couples the adapter to the device rack manifold. The flow control device may be configured to regulate a flow rate of liquid coolant through the liquid cooling loop subassembly. The adapter may be further incorporated into a rack assembly or multi-rack assembly to achieve thermal management of multiple computing systems with cooling loop subassemblies

Most of the foregoing alternative examples are not mutually exclusive but may be implemented in various combinations to achieve unique advantages. Additionally, the rack systems, tray level computing systems, cooling systems, and components disclosed are examples and can be further modified. As these and other variations and combinations of the features discussed above can be utilized without departing from the subject matter defined by the claims, the foregoing description of the embodiments should be taken by way of illustration rather than by way of limitation of the subject matter defined by the claims. As an example, the bistable hinge system is not limited to use in any one device and may be implemented across many products. The provision of the examples described herein, as well as clauses phrased as "such as," "including" and the like, should not be interpreted as limiting the subject matter of the claims to the specific examples; rather, the examples are intended to illustrate only one of many possible embodiments.

## Claims

1. An adapter for coupling a liquid cooling loop subassembly of a computing system to a device rack manifold, comprising:
a main body;
a first connector disposed on the main body, the first connector coupling the adapter to a coupling of the liquid cooling loop subassembly;
a second connector disposed on the main body, the second connector coupling the adapter to the device rack manifold;
a flow control device disposed between the first and second connectors, the flow control device configured to regulate a flow rate of liquid coolant through the liquid cooling loop subassembly.

2. The adapter of claim 1, wherein the main body comprises a hose, and the first connector is positioned at one end of the hose and the second connector is positioned at an opposed end of the hose.

3. The adapter of claim 1 or 2, wherein the first connector interlocks with the coupling of the liquid cooling subassembly and the second connector interlocks with the device rack manifold.

4. The adapter of any one of claims 1 to 3, wherein the coupling of the liquid cooling subassembly is one of a supply coupling and a return coupling.

5. The adapter of claim 3, wherein when the coupling of the liquid cooling subassembly is a supply coupling, the device rack manifold comprises a supply manifold, and the first connector couples the adapter to a supply coupling of the liquid cooling subassembly and the second connector couples the adapter to a supply inlet connection of the supply manifold; and/or
wherein when the coupling of the liquid cooling subassembly is a return coupling, the device rack manifold is a return manifold, and the first connector couples the adapter to a return coupling of the liquid cooling subassembly and the second connector couples the adapter to a return outlet connection of the return manifold.

6. The adapter of claim 5, wherein the supply inlet connection has a first configuration and the supply coupling has a second configuration that is incompatible with the first configuration, such that the supply coupling is unable to directly connect with the supply inlet connection; and/or
wherein the return outlet has a first configuration and the return coupling has a second configuration that is incompatible with the first configuration, such that the return coupling is unable to directly connect with the return outlet connection of the return manifold.

7. The adapter of any one of claims 1 to 6, wherein the flow control device comprises at least one of a valve and a pump.

8. The adapter of any one of claims 1 to 7, further comprising at least one of a monitoring device and a filter,
wherein the monitoring device is coupled to the main body, the monitoring device being configured to provide characteristics about the flow rate through the rack manifold, and
wherein the filter is coupled to the main body, the filter being configured to filter particulate matter in cooling liquid flowing through the adapter.

9. A device rack system comprising:
a supply manifold having a plurality of supply inlet connections configured to distribute a cooling liquid;
a return manifold having a plurality of return outlet connections configured to receive the cooling liquid;
a plurality of supply adapters, each of the plurality of supply adapters having a supply adapter manifold connection configured to connect with a corresponding one of the supply inlet connections and a supply coupling configured to couple with a corresponding cooling liquid subassembly; and
a plurality of return adapters, each of the plurality of return adapters having a return adapter manifold connection configured to connect with a corresponding one of the return outlet connections.

10. The device rack system of claim 9, wherein at least some of the plurality of supply adapters further comprise a flow control device to regulate a flow rate of the cooling liquid; and/or
wherein at least some of the plurality of return adapters further comprise a flow control device to regulate a flow rate of the cooling liquid.

11. The device rack system of claim 9 or 10, wherein the plurality of supply adapters each further comprise a hose with the supply adapter manifold connection at one end and the supply coupling at an opposed end, the supply adapter manifold connection interlocking with a corresponding one of the supply inlet connections; and/or
wherein the plurality of return adapters further comprise a return coupling configured to couple with the corresponding cooling liquid subassembly, wherein the plurality of return adapters each further comprise a hose with the return adapter manifold connection at one end of the hose and the return coupling positioned at an opposed end, the return adapter manifold connection interlocking with a corresponding one of the return outlet connections.

12. The device rack system of any one of claims 9 to 11, further comprising:
a plurality of computing systems;
a plurality of server tray shelves for housing computing systems; and
a plurality of cooling loop assemblies for cooling the plurality of computing systems, each cooling loop assembly corresponding to one of the server tray shelves and comprising:
one of the plurality of supply adapters;
one of the plurality of return adapters; and
one of the cooling loop subassemblies.

13. The device rack system of any one of claims 9 to 12, at least some of the supply adapters further comprising a main body having a monitoring device coupled to the main body, the monitoring device being configured to provide characteristics about flow rate of the cooling liquid through the at least some of the supply adapters; and/or
wherein at least some of the supply adapters further comprise a main body having a filter coupled to the main body, the filter being configured to filter particulate matter in cooling liquid flowing through the at least some of the adapters.

14. A method for cooling a computing system in a device rack comprising:
attaching a cooling loop assembly configured to cool components of the computing system to the device rack, the attaching comprising:
connecting a first connector of a supply adapter to a manifold supply inlet of a supply manifold for cooling liquid;
connecting a second connector of the supply adapter to a supply coupling of a pre-existing cooling loop subassembly;
connecting a first connector of a return adapter to a manifold return outlet of a return manifold configured to receive heating cooling liquid; and
connecting a second connector of the return adapter to a return coupling of the pre-existing cooling loop subassembly.

15. The method of claim 14, further comprising regulating a flow rate of cooling liquid flowing through the supply adapter by directing fluid into a fluid control device within the supply adapter.
